# EUROPÄISCHE PATENTANMELDUNG

(11) **EP 0 776 044 A2**
(43) Veröffentlichungstag der Anmeldung: **28.05.1997**
(21) Anmeldenummer: 96117876.1
(22) Anmeldetag: 07.11.1996
(51) Int. Cl.: H01L 27/108, H01L 21/8242, H01L 21/3205, H01L 27/115

(54) **Speicherzellenanordnung und Verfahren zu deren Herstellung**

(30) Priorität: 22.11.1995 DE 19543539
(71) Anmelder: SIEMENS AKTIENGESELLSCHAFT, 80333 München (DE)
(72) Erfinder: Risch, Lothar, Dr., D-85579 Neubiberg (DE); Bruchhaus, Rainer, Dr., D-80997 München (DE); Hofmann, Franz, Dr., D-80995 München (DE); Wersing, Wolfram, D-85551 Kirchheim (DE)

(57) **Zusammenfassung**

In einer Speicherzellenanordnung mit Stapelkondensatoren wird ein vertikaler Speicherkondensator mit einem ferroelektrischen oder paraelektrischen Speicherdielektrikum verwendet. Zur Herstellung des Speicherkondensators wird ganzflächig eine dielektrische Schicht (11) für das Speicherdielektrikum erzeugt. Anschließend wird die dielektrische Schicht (11) struktuiert und es werden erste Elektroden (13) und zweite Elektroden (16) für die Speicherkondensatoren gebildet. Die Erfindung ist für GBit-DRAM's und für nichtflüchtige Speicher geeignet.

## Beschreibung

Speicherzellenanordnungen, sowohl für DRAM-Anwendungen als auch für nichtflüchtige Speicher, weisen von Generation zu Generation eine erhöhte Speicherdichte auf.

In DRAM-Zellenanordnungen werden fast ausschließlich sogenannte Eintransistorspeicherzellen eingesetzt. Eine Eintransistorspeicherzelle umfaßt einen Auslesetransistor und einen Speicherkondensator. In dem Speicherkondensator ist die Information in Form einer elektrischen Ladung gespeichert, die eine logische Größe, Null oder Eins, darstellt. Durch Ansteuerung des Auslesetransistors über eine Wortleitung kann diese Information über eine Bitleitung ausgelesen werden. Zur sicheren Speicherung der Ladung und gleichzeitigen Unterscheidbarkeit der ausgelesenen Information muß der Speicherkondensator eine Mindestkapazität aufweisen. Die untere Grenze für die Kapazität des Speicherkondensators wird derzeit bei 20 fF gesehen.

Da von Speichergeneration zu Speichergeneration die Speicherdichte zunimmt, muß die benötigte Fläche der Eintransistorspeicherzelle von Generation zu Generation reduziert werden. Gleichzeitig muß die Mindestkapazität des Speicherkondensators erhalten bleiben.

Bis zur 1 MBit-Generation wurden sowohl der Auslesetransistor als auch der Speicherkondensator als planare Bauelemente realisiert. Ab der 4 MBit-Speichergeneration wurde eine weitere Flächenreduzierung der Speicherzelle durch eine dreidimensionale Anordnung von Auslesetransistor und Speicherkondensator erzielt. Eine Möglichkeit besteht darin, den Speicherkondensator in einem Graben zu realisieren. Die Elektroden des Speicherkondensators sind in diesem Fall entlang der Oberfläche des Grabens angeordnet. Dadurch wird die effektive Fläche des Speicherkondensators, von der die Kapazität abhängt, gegenüber dem Platzbedarf an der Oberfläche des Substrats für den Speicherkondensator, der dem Querschnitt des Grabens entspricht, vergrößert.

Eine weitere Möglichkeit zur Vergrößerung der Speicherkapazität bei gleichbleibendem oder verringertem Platzbedarf des Speicherkondensators besteht darin, den Speicherkondensator als Stapelkondensator, den sogenannten stacked capacitor, auszuführen. Dabei wird über den Wortleitungen eine Struktur aus Polysilizium, zum Beispiel ein Zylinder, eine Kronenstruktur oder eine Rippenstruktur (FIN), gebildet, die mit dem Substrat kontaktiert wird. Diese Polysiliziumstruktur bildet den Speicherknoten. Er wird mit Kondensatordielektrikum und Kondensatorplatte versehen. Dabei wird für den Speicherkondensator der freie Raum oberhalb der Substratoberfläche genutzt. Es kann die gesamte Zellfläche von der Polysiliziumstruktur überdeckt sein, solange die Polysiliziumstrukturen zu benachbarten Speicherzellen gegeneinander isoliert sind. Dieses Konzept hat den Vorzug, daß es weitgehend mit einem Logikprozeß kompatibel ist.

Die Fläche für eine Speicherzelle eines DRAM in der 1 GBit-Generation soll nur etwa 0,2 µm² betragen. Um auf einer derartigen Fläche die Mindestkapazität für den Speicherkondensator von ca. 25 fF zu realisieren, muß, bei einem Grabenkondensatorkonzept, die aktive Grabentiefe mindestens 8 µm bei einer Grabenweite von 0,3 µm und einem Dielektrikum mit einer oxidäquivalenten Dicke von 4 nm betragen. Gräben mit derartigen Abmessungen sind nur in aufwendigen Ätzprozessen mit hohen Ätzzeiten realisierbar. In einem Stapelkondensatorkonzept sind diese Anforderungen an den Flächenbedarf einer Speicherzelle nur mit einer relativ komplizierten Struktur der Polysiliziumstruktur machbar. Diese komplizierten Strukturen sind zusätzlich durch ihre Topologie immer schwieriger herstellbar.

Eine weitere Erhöhung der pro Flächeneinheit erzielbaren Kapazität wird durch Einsatz von sogenannten Hochepsilon-Dielektrika als Speicherdielektrikum im Speicherkondensator erreicht (siehe zum Beispiel P. C. Fazan, Integrated Ferroelectrics, Band 4 (1994), Seiten 247 bis 256). Hochepsilon-Dielektrika sind ferro- oder paraelektrische Materialien. In diesen Konzepten wird der Kondensator als Stapelkondensator ausgeführt. Dazu wird zunächst eine untere Elektrode durch Schichtabscheidung und -strukturierung erzeugt. Darauf wird das hochepsilon Dielektrikum abgeschieden. Abschließend wird eine obere Kondensatorelektrode aufgebracht, strukturiert und mit einem elektrischen Kontakt versehen. Da die Abscheidung von Hochepsilon-Dielektrika bei Temperaturen im Bereich 700 bis 800°C erfolgt, bei der viele Elektrodenmaterialien reagieren, sind für die unteren Elektroden nur spezielle Materialien, zum Beispiel TiN, Pt, W, RuO₂, Ir₂O₃ oder Pd geeignet. Die Suche nach weiteren für die untere Elektrode geeigneten Materialien ist Gegenstand weltweiter Forschungsaktivitäten.

Der Erfindung liegt das Problem zugrunde, eine Speicherzellenanordnung anzugeben, die für hochintegrierte DRAMs der 1 Gbit- und nachfolgenden Generationen geeignet ist und die mit gegenüber den bekannten Lösungen reduziertem Prozeßaufwand herstellbar ist. Ferner soll ein Herstellverfahren für eine solche Speicherzellenanordnung angegeben werden.

Dieses Problem wird erfindungsgemäß gelöst durch eine Speicherzellenanordnung gemäß Anspruch 1 sowie ein Verfahren gemäß Anspruch 6. Weitere Ausgestaltungen der Erfindung gehen aus den übrigen Ansprüchen hervor.

Die erfindungsgemäße Speicherzellenanordnung umfaßt eine Vielzahl einzelner Speicherzellen, die jeweils einen Auswahltransistor und einen Speicherkondensator umfassen. Die Speicherkondensatoren sind dabei nach Art von Stapelkondensatoren (stacked capacitor) in einer Ebene oberhalb der Auswahltransistoren angeordnet. Die Auswahltransistoren sind mit einer isolierenden Schicht bedeckt.

Die Speicherkondensatoren umfassen jeweils eine erste Elektrode, ein Speicherdielektrikum und eine zweite Elektrode. Dabei sind die erste Elektrode, das Speicherdielektrikum und die zweite Elektrode jeweils nebeneinander oberhalb der isolierenden Schicht angeordnet. Die Kapazität des Speicherkondensators wird durch die Fläche zwischen erster Elektrode und Speicherdielektrikum und zweiter Elektrode und Speicherdieleketrikum bestimmt. Diese Fläche und damit die Kapazität des Speicherkondensators ist in der erfindungsgemäßen Anordnung über die Höhe der ersten und zweiten Elektrode sowie des Speicherdielektrikums einstellbar.

Eine Kondensatoranordnung für Speicher mit einem vertikalen Kondensator ist zwar bereits in DE-OS 43 36 001 vorgeschlagen worden. Als Speicherdielektrikum wird dort jedoch eine monokristalline, ferroelektrische Schicht verwendet, so daß der Kondensator nur auf einem monokristallinen Substrat herstellbar ist. Für eine Stacked-capacitor-Anordnung ist die bekannte Kondensatoranordnung daher ungeeignet.

Als Speicherdielektrikum wird ferroelektrisches und/oder paraelektrisches Material verwendet. Ferroelektrische und paraelektrische Materialien sind kristalline Materialien mit einem polaren Gitter. In diesen Materialien überwiegt die ionische Bindung. Sie weisen eine hohe Dielektrizitätskonstante ε auf. Die Dielektrizitätskonstante ε von vielen ferroelektrischen und paraelektrischen Materialien liegt zwischen 300 und 1000. Amorphe Dielektrika, wie zum Beispiel SiO₂ oder Si₃N₄ weisen dagegen Dielektrikzitätskonstanten ε um 3 auf. Die erhöhte Ladungsspeicherung in ferroelektrischen und paraelektrischen Materialien wird mit einer höheren Verschiebung der Ladungen durch molekulare Dipole erklärt.

Für DRAM-Anwendungen werden vorzugsweise paraelektrische Materialien als Speicherdielektrikum verwendet, da in diesen die Polarisation linear von einem angelegten elektrischen Feld abhängt. Ferroelektrische Materialien werden vorzugsweise für nichtflüchtige Speicher verwendet, da diese Materialien eine spontane Polarisation aufweisen, die auch ohne angelegtes elektrisches Feld vorhanden ist. In nichtflüchtigen Speichern wird die Ausrichtung der Polarisation, die durch ein angelegtes elektrisches Feld umgeschaltet werden kann, den logischen Variablen Null und Eins zugeordnet.

Für das Speicherdielektrikum werden vorzugsweise folgende ferroelektrische Materialien verwendet: Bleizirkonattitanat, BaTiO₃, Bleilanthantitanat, Strontiumwismuttantalat SrBi₂Ta₂O₉, Wismuttitanat Bi₄Ti₃O₁₂, oder folgende paraelektrische Materialien verwendet: Bariumstrontiumtitanat, Strontiumtitanat, Bariumzirkonattitanat.

Zur Herstellung der erfindungsgemäßen Speicherzellenanordnung werden zunächst in einem Halbleiterschichtaufbau die Auswahltransistoren erzeugt und mit einer isolierenden Schicht abgedeckt. Anschließend wird ganzflächig eine dielektrische Schicht aus dem Material für die Speicherdielektrika erzeugt. In der dielektrischen Schicht werden erste Öffnungen gebildet, deren Tiefe mindestens der Dicke der dielektrischen Schicht entspricht. Das heißt, die ersten Öffnungen reichen durch die gesamte Dicke der dielektrischen Schicht hindurch. In den ersten Öffnungen werden die ersten Elektroden gebildet. In der dielektrischen Schicht werden ferner zweite Öffnungen erzeugt, deren Tiefe mindestens der Dicke der dielektrischen Schicht entspricht. Auch die zweiten Öffnungen durchqueren die dielektrische Schicht in ihrer gesamten Dicke. In den zweiten Öffnungen werden die zweiten Elektroden für die Speicherkondensatoren gebildet. Zwischen den ersten Elektroden und dem jeweils zugehörigen Auswahltransistor wird ein Zellkontakt gebildet. Der Zellkontakt wird in der isolierenden Schicht erzeugt. Die ersten Öffnungen reichen vorzugsweise auf den jeweiligen Zellkontakt.

Da in dem erfindungsgemäßen Verfahren zunächst die dielektrische Schicht erzeugt wird und erst später die ersten und zweiten Elektroden gebildet werden, sind die ersten und zweiten Elektroden den Temperaturbelastungen bei der Bildung der dielektrischen Schicht aus paraelektrischem oder ferroelektrischem Material nicht unterworfen. Damit entspannt sich das Materialproblem für die ersten und zweiten Elektroden des Speicherkondensators und vor allem für eine leitfähige Barriere zwischen Drain des Auswahltransistors und der Elektrode des Kondensators.

Vorzugsweise werden die Wortleitungen und die Bitleitungen ebenfalls vor der Abscheidung der dielektrischen Schicht erzeugt und mit der isolierenden Schicht abgedeckt. Die Speicherzellenanordnung ist dann bis auf den Speicherkondensator mit der dielektrischen Schicht aus paraelektrischem oder ferroelektrischem Material abgeschlossen. Nach der Erzeugung des Speicherkondensators, die nicht VLSI-kompatibel ist, sind dann keine zusätzlichen VLSI-Prozeßschritte mehr erforderlich.

Vorzugsweise wird die isolierende Schicht mit einer planaren Oberfläche erzeugt. Dies erfolgt zum Beispiel durch chemischmechanisches Polieren. Auf der planaren Oberfläche kann die dielektrische Schicht durch Sputtern oder mit Hilfe des Sol-Gel-Verfahrens abgeschieden werden. Weist die isolierende Schicht keine ausreichend planare Oberfläche auf, so wird die dielektrische Schicht in einem CVD-Verfahren abgeschieden.

Es ist vorteilhaft, auf die Oberfläche der isolierenden Schicht zunächst eine Bufferschicht aufzubringen, auf der die dielektrische Schicht aus ferroelektrischem oder paraelektrischem Material texturiert aufwächst. Dadurch besteht sie aus homogenem Material, das auch bei einer Strukturierung mit Strukturgrößen in der Größenordnung 100 nm gleichbleibende Materialeigenschaften aufweist. Dadurch werden Probleme entschärft, die bei der Verwendung polykristalliner Schichten bei kleinen Strukturgrößen durch verstärkten Einfluß von Korngrenzen auftreten.

Die Bufferschicht wird vorzugsweise aus ZrO₂, TiO₂ oder Ta₂O₅ gebildet. Auf dieser Bufferschicht wachsen Ferroelektrika mit Bi₂O₃-Oxidlagenstruktur wie beispielsweise Bi₄Ti₃O₁₂ oder SrBi₂Ta₂O₉ unmittelbar texturiert auf. Die Bi₂O₃-Ebenen sind dabei parallel zur Oberfläche ausgerichtet. Sollen auch andere Ferroelektrika wie die meistens eingesetzten Ferroelektrika mit Perowskitstruktur (zum Beispiel BaTiO₃, PbTiO₃, Pb(ZrTi)O₃) texturiert abgeschieden werden, so wird zunächst über der Bufferschicht aus ZrO₂ eine zweite dünne Schicht aus Bi₄Ti₃O₁₂ oder ähnlichem abgeschieden, auf der die ferroelektrische Schicht texturiert aufwächst.

Wird die dielektrische Schicht aus ferroelektrischem Material gebildet, so hat das texturierte Aufwachsen auf einer Bufferschicht zusätzlich den Vorteil, daß die dielektrische Schicht eine definierte Orientierung der spontanen Polarisation aufweist. Die spontane Polarisation in den Domänen der ferroelektrischen Schicht liegt in einer Ebene parallel zur Richtung des angelegten elektrischen Feldes. Damit läßt sich die Polarisation von einem Zustand in den anderen umschalten. Dies ist besonders vorteilhaft, wenn Bi₂O₃-Lagen Ferroelektrika wie zum Beispiel Bi₄Ti₃O₁₂ zum Einsatz kommen, da bei ihnen die Hauptkomponente der spontanen Polarisation parallel zu den Bi₂O₃-Ebenen liegt und diese in der vorliegenden Anordnung vollständig zur Datenspeicherung genutzt werden kann.

Zur Bildung der Zellkontakte liegt es im Rahmen der Erfindung, in der isolierenden Schicht Kontaktlöcher zu bilden, die mit den Zellkontakten aufgefüllt werden. Anschließend werden die ersten Öffnungen in der dielektrischen Schicht so angeordnet, daß die Oberfläche der Zellkontakte in den ersten Öffnungen mindestens teilweise freigelegt wird. Die anschließend in den ersten Öffnungen gebildeten ersten Elektroden sind auf diese Weise direkt mit den Zellkontakten verbunden.

Im folgenden wird die Erfindung anhand der Ausführungsbeispiele und der Figuren näher erläutert.
- Figur 1: zeigt einen Halbleiterschichtaufbau mit Auswahltransistoren, Bitleitungen, Wortleitungen, einer isolierenden Schicht und Zellkontakten, auf die eine Bufferschicht und eine dielektrische Schicht aufgebracht wurden.
- Figur 2: zeigt den Halbleiterschichtaufbau nach Bildung von ersten Öffnungen und ersten Elektroden in der dielektrischen Schicht und nach Abscheidung einer Isolationsschicht.
- Figur 3: zeigt den Halbleiterschichtaufbau nach Bildung von zweiten Öffnungen und zweiten Elektroden in der dielektrischen Schicht und Bildung einer Kondensatorplatte.
- Figur 4: zeigt den in Figur 3 mit IV-IV bezeichneten Schnitt durch den Halbleiterschichtaufbau.
- Figur 5: zeigt einen Halbleiterschichtaufbau mit Auswahltransistoren, Wortleitungen, Bitleitungen, einer isolierenden Schicht, Zellkontakten und einem oberhalb der isolierenden Schicht angeordneten Speicherkondensator.
- Figur 6: zeigt den in Figur 5 mit VI-VI bezeichneten Schnitt durch den Halbleiterschichtaufbau.

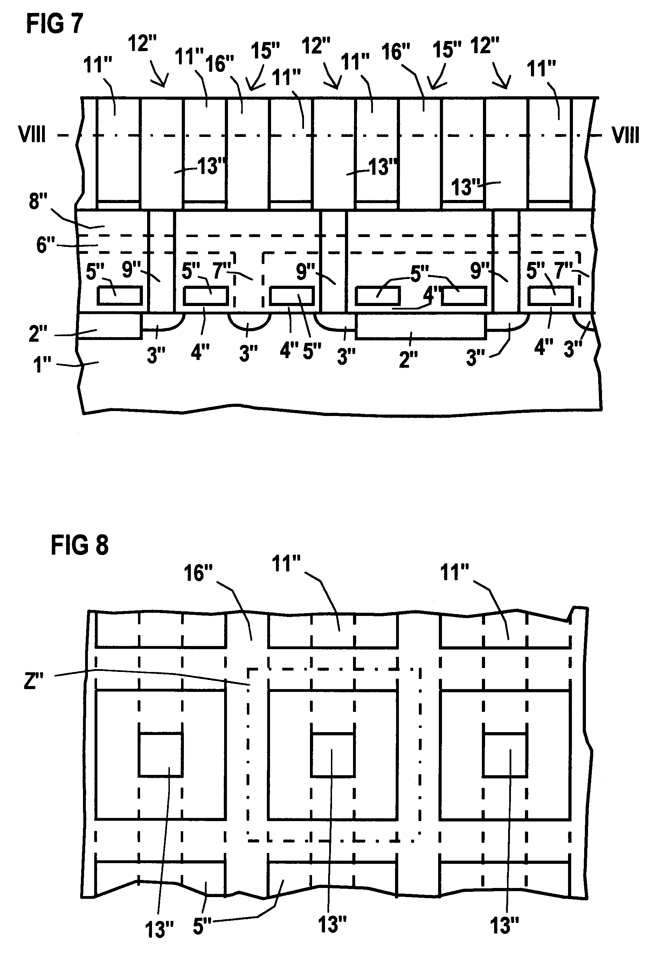

- Figur 7: zeigt einen Schnitt durch einen Halbleiterschichtaufbau mit Auswahltransistoren, Bitleitungen, Wortleitungen, einer isolierenden Schicht, Zellkontakten und einem Speicherkondensator, dessen erste und zweite Elektroden durch Abscheiden einer leitfähigen Schicht gebildet worden sind.
- Figur 8: zeigt den in Figur 7 mit VIII-VIII bezeichneten Schnitt durch den Halbleiterschichtaufbau.

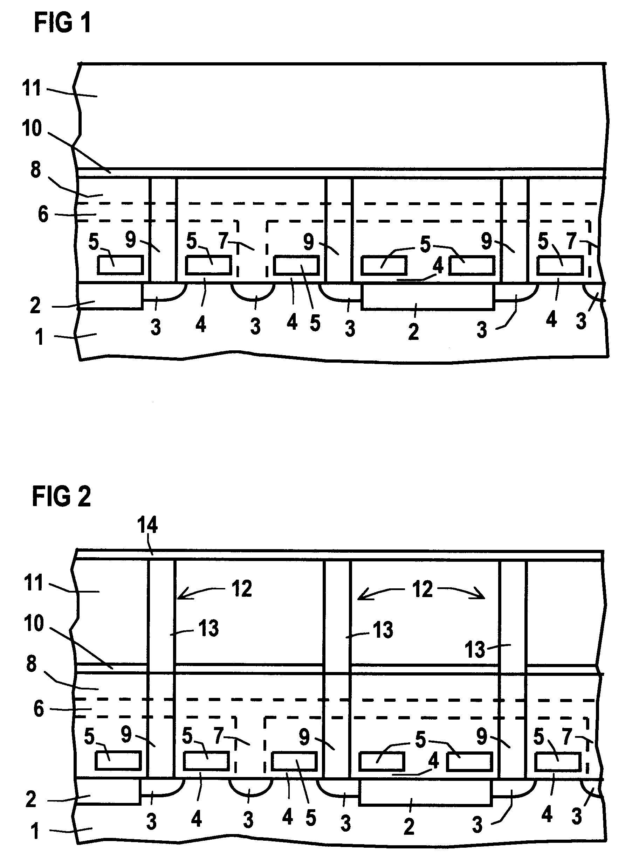

In einem Substrat 1 aus zum Beispiel monokristallinem Silizium werden Isolationsstrukturen 2 zur Isolation benachbarter Auswahltransistorpaare im Substrat 1 gebildet. Die Isolationsstrukturen 2 werden zum Beispiel aus SiO₂ zum Beispiel in einem LOCOS-Prozeß durch selektive Oxidation oder in einem Shallow Trench Prozeß durch Ätzung eines Grabens, der mit isolierendem Material aufgefüllt wird, gebildet (siehe Figur 1).

Anschließend werden Auswahltransistorpaare gebildet mit Source/Drain-Gebieten 3, Gateoxid 4 und als Wortleitungen 5 ausgebildeten Gateelektroden. Die Auswahltransistorpaare weisen jeweils ein gemeinsames Source/Drain-Gebiet 3 auf, über das die beiden Auswahltransistoren miteinander verbunden sind. Die Wortleitungen 5 verlaufen senkrecht zur Schnittebene über die Speicherzellenanordnung.

Oberhalb der Wortleitungen 5 verlaufen parallel zur Schnittebene Bitleitungen 6, die jeweils über Bitleitungskontakte 7 mit dem gemeinsamen Source/Drain-Gebiet 3 der Auswahltransistorpaare elektrisch verbunden sind. Die Bitleitung 6 und die Bitleitungskontakte 7 sind in Figur 1 gestrichelt gezeichnet, da sie parallel zur Schnittebene außerhalb der Schnittebene verlaufen.

Auswahltransistorpaare, die zu benachbarten Wortleitungspaaren gehören sind im Substrat 1 jeweils versetzt angeordnet.

Es wird eine isolierende Schicht 8 zum Beispiel aus SiO₂ gebildet, die die Auswahltransistoren, die Wortleitungen 5 und die Bitleitungen 6 vollständig bedeckt. Die isolierende Schicht 8 wird zum Beispiel durch BPSG und anschließende Planarisierung, zum Beispiel durch chemisch-mechanisches Polieren, gebildet. Die isolierende Schicht 8 weist eine im wesentlichen planare Oberfläche auf.

In der isolierenden Schicht 8 werden anschließend Kontaktlöcher geöffnet und mit Zellkontakten 9 versehen. Die Zellkontakte 9 werden zum Beispiel aus Wolfram gebildet. Die Zellkontakte 9 reichen jeweils auf die äußeren Source/Drain-Gebiete 3 der Auswahltransistoren (siehe Figur 1).

Es wird ganzflächig eine Hilfsschicht 10 abgeschieden. Die Hilfsschicht 10 wird zum Beispiel aus Si₃N₄ oder ZrO₂ gebildet.

Anschließend wird eine dielektrische Schicht 11 ganzflächig abgeschieden. Die dielektrische Schicht 11 wird zum Beispiel aus Strontium-Titanat im Temperaturbereich 600 bis 700°C durch Sputtern abgeschieden. In diesem Fall besteht die dielektrische Schicht 11 aus paraelektrischem Material. Alternativ kann die dielektrische Schicht 11 aus ferroelektrischem Material gebildet werden durch Abscheidung von BaTiO₃, Bi₄Ti₃O₁₂ oder Bleizirkonattitanat im Temperaturbereich 500 bis 700°C. Die Hilfsschicht 10 schützt bei der Abscheidung der dielektrischen Schicht 11 die Zellkontakte 9 vor unerwünschten Reaktionen. Ferner dient die Hilfsschicht 10 als Bufferschicht, auf der die dielektrische Schicht 11 texturiert aufgewachsen werden kann. Wird die dielektrische Schicht 11 aus Bi₄Ti₃O₁₂ gebildet, so wird die Hilfsschicht vorzugsweise aus ZrO₂ vorgesehen. Die dielektrische Schicht 11 wird in einer Dicke von zum Beispiel 500 nm durch Sputtern abgeschieden.

Anschließend werden in der dielektrischen Schicht 11 erste Öffnungen 12 gebildet, deren Anordnung der Anordnung der Zellkontakte entspricht und die die Oberfläche des Zellkontaktes 9 jeweils mindestens teilweise freilegen. Dabei wird sowohl die dielektrische Schicht 11 als auch die Hilfsschicht 10 durchätzt (siehe Figur 2). Die ersten Öffnungen 12 werden mit ersten Elektroden 13 versehen, die zum Beispiel aus Aluminium, Kupfer oder Wolfram gebildet werden und die die ersten Öffnungen 12 vorzugsweise vollständig auffüllen. Vorzugsweise weisen die ersten Öffnungen 12 die Form von Kontaktlöchern auf, so daß die ersten Elektroden 13 säulenförmig ausgebildet sind.

Es wird ganzflächig eine Isolationsschicht 14 zum Beispiel aus SiO₂ in einer Dicke von zum Beispiel 50 nm bis 200 nm abgeschieden.

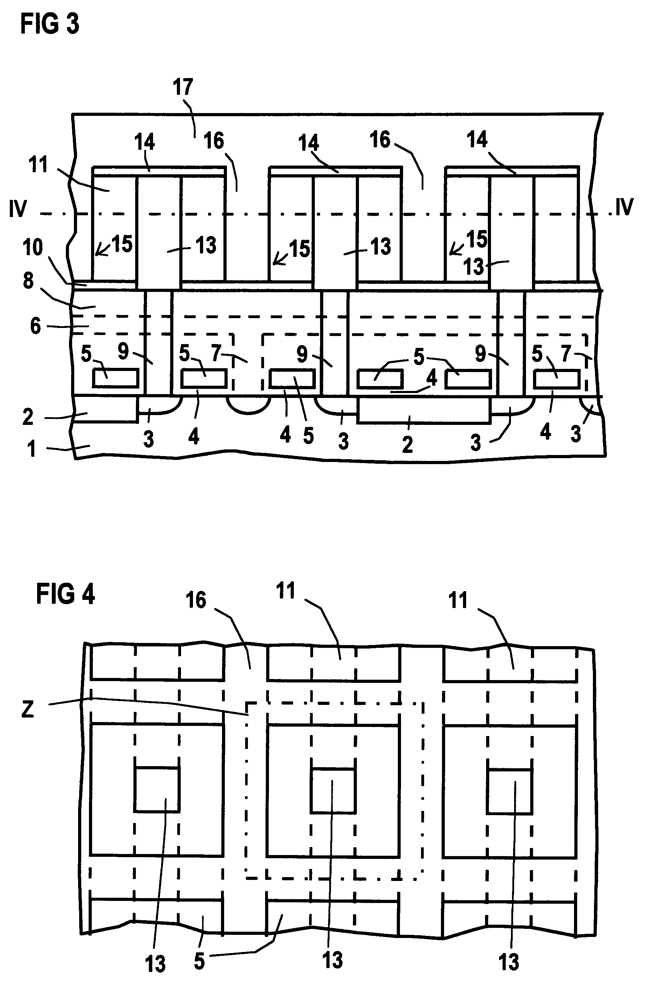

Anschließend werden zweite Öffnungen 15 gebildet, die durch die Isolationsschicht 14 und die dielektrische Schicht 11 hindurchreichen. In den zweiten Öffnungen 14 ist die Oberfläche der Hilfsschicht 10 freigelegt (siehe Figur 3). Die zweiten Öffnungen 15 werden durch Abscheidung einer leitfähigen Schicht zum Beispiel aus Aluminium, Kupfer oder Wolfram aufgefüllt. Dabei werden in den zweiten Öffnungen 15 zweite Elektroden 16 gebildet. Gleichzeitig wird eine Kondensatorplatte 17 gebildet, die die zweiten Elektroden 16 elektrisch miteinander verbindet.

Die zweiten Elektroden 16 umgeben die ersten Elektroden 13 jeweils ringförmig (siehe Aufsicht in Figur 4).

Zweite Elektroden 16, die benachbarten Speicherzellen angehören, stoßen zusammen und sind damit elektrisch miteinander verbunden.

Die zweiten Elektroden 16 sind gegenüber den ersten Elektroden 13 durch die strukturierte dielektrische Schicht 11 sowie die strukturierte Isolationsschicht 14 isoliert. Die strukturierte dielektrische Schicht 11 umgibt die säulenförmigen ersten Elektroden 13 ebenfalls ringförmig.

In Figur 4 ist als strichpunktierte Linie mit dem Bezugszeichen Z die Fläche einer Speicherzelle eingetragen. Werden die ersten Elektroden 13 in der Breite einer minimal herstellbaren Strukturgröße F, die Weite der strukturierten dielektrischen Schicht 11 ebenfalls entsprechend F und die Weite der zweiten Elektroden 16 ebenfalls entsprechend F eingestellt, so beträgt die Fläche der Speicherzelle Z 16 F². Die Kondensatorfläche beträgt 8 F x h, wobei h die Höhe der dielektrischen Schicht 11 ist.

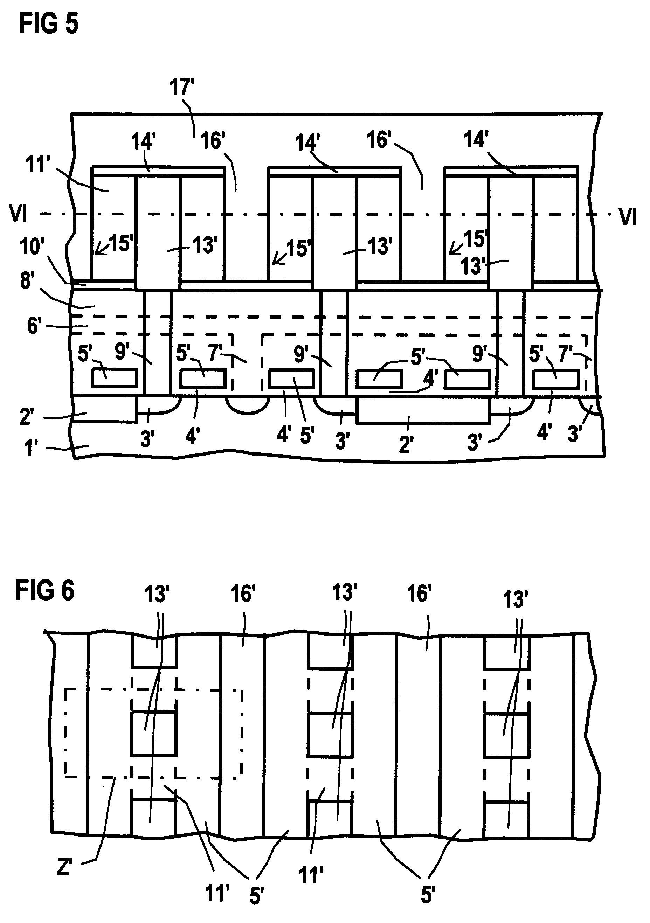

In einem zweiten Ausführungsbeispiel ist eine Speicherzellenanordnung analog der anhand von Figur 1 bis 4 erläuterten Speicherzellenanordnung in einem Substrat 1' realisiert (siehe Figur 5). Sie weist im Substrat 1' Isolationsstrukturen 2', Auswahltransistoren mit Source/Drain-Gebieten 3', Gateoxid 4' und Wortleitungen 5', Bitleitungen 6' und Bitleitungskontakte 7' auf, die von einer isolierenden Schicht 8' mit planarer Oberfläche bedeckt sind. In der isolierenden Schicht 8' sind Zellkontakte 9' zu den Auswahltransistoren vorgesehen. Oberhalb der isolierenden Schicht 8' sind Speicherkondensatoren angeordnet, die jeweils eine erste Elektrode 13', eine zweite Elektrode 16' und eine strukturierte dielektrische Schicht 11' aufweisen. Zwischen der strukturierten dielektrischen Schicht 11' und der isolierenden Schicht 8' ist eine Hilfsschicht 10' angeordnet. Die zweiten Elektroden 16' sind über eine Kondensatorplatte 17' elektrisch miteinander verbunden. Gegenüber den ersten Elektroden 13' sind die zweiten Elektroden 16' und die Kondensatorplatte 17' über eine Isolationsschicht 14' isoliert.

Die Herstellung dieser Speicherzellenanordnung erfolgt entsprechend der anhand von Figur 1 bis 4 erläuterten Speicherzellenanordnung. Die verschiedenen Komponenten werden entsprechend den entsprechenden Komponenten im ersten Ausführungsbeispiel ausgeführt.

Im Unterschied zum ersten Ausführungsbeispiel weisen die zweiten Elektroden 16' einen streifenförmigen Verlauf auf und verlaufen parallel zu den Wortleitungen 5' über die Speicherzellenanordnung (siehe Aufsicht in Figur 6). Die ersten Elektroden 13' sind wie im ersten Ausführungsbeispiel säulenförmig ausgebildet. Die minimale Fläche für eine Speicherzelle Z' beträgt im zweiten Ausführungsbeispiel 8 F2, das heißt die Speicherzellenanordnung ist im zweiten Ausführungsbeispiel mit erhöhter Packungsdichte herstellbar. Die Kondensatorfläche beträgt 2 x F x H, wobei H die Dicke der dielektrischen Schicht 11' ist. Über die Dicke der dielektrischen Schicht 11' läßt sich die Kondensatorfläche des Speicherkondensators einstellen.

In einem dritten Ausführungsbeispiel werden in einem Substrat 1'' aus monokristallinem Silizium Isolationsstrukturen 2'' und Auswahltransistoren mit Source/Drain-Gebieten 3'', Gateoxid 4'' und Wortleitungen 5'' gebildet. Es werden Bitleitungen 6'' und Bitleitungskontakte 7'' sowie eine isolierende Schicht 8'', die die Bitleitungen 6'', die Wortleitungen 5'' und die Auswahltransistoren bedeckt und die eine planare Oberfläche aufweist, erzeugt. In der isolierenden Schicht 8'' werden Zellkontakte 9'' durch Kontaktlochöffnung und Abscheidung von zum Beispiel Wolfram gebildet.

Auf die isolierende Schicht 8'' wird eine Hilfsschicht 10'' und darauf eine dielektrische Schicht 11'' aufgebracht. Bis hierher erfolgt die Herstellung wie im ersten und zweiten Ausführungsbeispiel. Die verschiedenen Komponenten werden entsprechend den entsprechenden Komponenten in den anderen Ausführungsbeispielen ausgeführt.

Anschließend werden in der dielektrischen Schicht 11'' und der Hilfsschicht 10'' gleichzeitig erste Öffnungen 12'' und zweite Öffnungen 15'' erzeugt. Die ersten Öffnungen 12'' reichen jeweils auf die Oberfläche der Zellkontakte 9''. Die zweiten Öffnungen 15'' umgeben die ersten Öffnungen 12'' jeweils ringförmig (siehe Aufsicht in Figur 8).

Anschließend wird ganzflächig eine leitfähige Schicht abgeschieden, die sowohl die ersten Öffnungen 12'' als auch die zweiten Öffnungen 15'' vollständig auffüllt. Die leitfähige Schicht wird rückgeätzt, so daß zwischen den ersten Öffnungen 12'' und den zweiten Öffnungen 15'' die Oberfläche der dielektrischen Schicht 11'' freigelegt ist. Dadurch entstehen in den ersten Öffnungen 12'' erste Elektroden 13'' und in den zweiten Öffnungen 15'' zweite Elektroden 16''. Zweite Elektroden 16'' zu benachbarten Speicherzellen stoßen zusammen und sind auf diese Weise miteinander elektrisch verbunden. Die zweiten Elektroden 16'' sind von den ersten Elektroden 13'' über die strukturierte dielektrische Schicht 11'' isoliert. Die zweiten Elektroden 16'' werden am Rand der Speicherzellenanordnung kontaktiert.

In dieser Ausführungsform der Erfindung wird zur Bildung der ersten Öffnungen 12'' und der zweiten Öffnungen 15'' nur eine Maske benötigt. Zur Bildung der ersten Elektroden 13'' und der zweiten Elektroden 16'' ist die Abscheidung einer leitfähigen Schicht ausreichend. Die ersten Elektroden 13'' und die zweiten Elektroden 16'' werden zum Beispiel aus Aluminium, Kupfer oder Wolfram gebildet.

Die minimale Fläche einer Speicherzelle Z'' beträgt in diesem Ausführungsbeispiel, wie im ersten Ausführungsbeispiel, 16 F², wobei F die minimale herstellbar Strukturgröße ist. Die Fläche des Speicherkondensators trägt 8 F x h, wobei h die Dicke der dielektrischen Schicht 11'' ist.

Der Zellentyp, in dem die Speicherzellen der Ausführungsbeispiele ausgeführt sind, wird oft als folded bitline Stacked Zelle bezeichnet. Die Anordnung der Wortleitungen und Bitleitungen entspricht einer Capacitor over Bitline-Ausführung.

## Patentansprüche

1. Speicherzellenanordnung,
- bei der in einem Halbleiterschichtaufbau eine Vielzahl einzelner Speicherzellen vorgesehen sind, die jeweils einen Auswahltransisstor und einen Speicherkondensator umfassen,
- bei der im wesentlichen parallel verlaufende Bitleitungen (6) und im wesentlichen parallel verlaufende Wortleitungen (5) vorgesehen sind, die quer zueinander verlaufen,
- bei der mindestens die Auswahltransistoren unterhalb einer isolierenden Schicht (8) angeordnet sind,
- bei der die Speicherkondensatoren (13, 11, 16) auf der isolierenden Schicht (8) angeordnet sind,
- bei der die Speicherkondensatoren jeweils eine erste Elektrode (13), ein Speicherdielektrikum (11) und eine zweite Elektrode (16) umfassen,
- bei der das Speicherdielektrikum (11) ferroelektrisches oder paraelektrisches Material umfaßt,
- bei der die erste Elektrode (13), das Speicherdielektrikum (11) und die zweite Elektrode (16) jeweils nebeneinander oberhalb der isolierenden Schicht (8) angeordnet sind.

2. Speicherzellenanordnung nach Anspruch 1,
bei der das Speicherdielektrikum (11) mindestens einen der Stoffe BaTiO₃, SrTiO₃, (Ba, Sr)TiO₃, Ba(Ti,Zr)O₃, Bleizirkonattitanat, Bi₄Ti₃O₁₂, SrBi₂Ta₂O₉ umfaßt.

3. Speicherzellenanordnung nach Anspruch 1 oder 2,
bei der die Bitleitungen (6) und die Wortleitungen (5) unterhalb der isolierenden Schicht (8) angeordnet sind.

4. Speicherzellenanordnung nach einem der Ansprüche 1 bis 3,
- bei der das Speicherdielektrikum (11) die erste Elektrode (13) ringförmig umgibt,
- bei der die zweiten Elektroden (16) das Speicherdielektrikum (11) jeweils ringförmig umgeben,
- bei der die zweiten Elektroden (16) benachbarter Speicherkondensatoren miteinander verbunden sind.

5. Speicherzellenanordnung nach einem der Ansprüche 1 bis 3, bei der die zweiten Elektroden (16) über eine Kondensatorplatte (17), die oberhalb der ersten Elektroden (13) und der Speicherdielektrika (11) angeordnet ist und die gegen die ersten Elektroden (13) isoliert ist, miteinander verbunden sind.

6. Verfahren zur Herstellung einer Speicherzellenanordnung,
- bei dem ein Halbleiterschichtaufbau mit einer Vielzahl einzelner Speicherzellen erzeugt wird, die jeweils einen Auswahltransistor und einen Speicherkondensator umfassen,
- bei dem in dem Halbleiterschichtaufbau zunächst die Auswahltransistoren, Bitleitungen (6) und Wortleitungen (5) erzeugt werden,
- bei dem eine isolierende Schicht (8) erzeugt wird, die die Auswahltransistoren abdeckt,
- bei dem ganzflächig eine dielektrische Schicht (8) erzeugt wird,
- bei dem in der dielektrischen Schicht (11) erste Öffnungen (12) erzeugt werden, deren Tiefe mindestens der Dicke der dielektrischen Schicht (11) entspricht,
- bei dem in den ersten Öffnungen (12) erste Elektroden (13) für die Speicherkondensatoren gebildet werden,
- bei dem in der dielektrischen Schicht (11) zweite Öffnungen (15) erzeugt werden, deren Tiefe mindestens der Tiefe der dielektrischen Schicht (11) entspricht,
- bei dem in den zweiten Öffnungen (15) zweite Elektroden (16) für den Speicherkondensator gebildet werden,
- bei dem jeweils zwischen den ersten Elektroden (13) und einem der Auswahltransistoren ein Zellkontakt (9) gebildet wird.

7. Verfahren nach Anspruch 6,
- bei dem zur Bildung der Zellkontakte (9) in der isolierenden Schicht (8) Kontaktlöcher geöffnet werden, die mit den Zellkontakten (9) aufgefüllt werden,
- bei dem die ersten Öffnungen (12) so angeordnet werden, daß die Oberfläche der Zellkontakte (9) in den ersten Öffnungen (12) mindestens teilweise freigelegt wird.

8. Verfahren nach Anspruch 6 oder 7,
bei die dielektrische Schicht (11) mindestens eine Schicht aus ferroelektrischem oder paraelektrischem Material umfaßt.

9. Verfahren nach Anspruch 8,
bei dem auf die isolierende Schicht (8) zunächst eine Bufferschicht (10) aufgebracht wird, auf der die dielektrische Schicht (11) epitaktisch aufwächst.

10. Verfahren nach Anspruch 8 oder 9,
bei dem die Schicht aus ferroelektrischem oder paraelektrischem Material mindestens einen der Stoffe BaTiO₃, SrTiO₃, (Ba,Sr)TiO₃, Ba(Ti,Zr)O₃, Bleizirkonattitanat, Bi₄Ti₃O₁₂, SrBi₂Ta₂O₉ enthält.

11. Verfahren nach einem der Ansprüche 6 bis 10,
- bei dem die ersten Öffnungen (12) und die zweiten Öffnungen (15) in der dielektrischen Schicht (11) in einem gemeinsamen Strukturierungsschritt gebildet werden,
- bei dem die ersten Öffnungen (12) jeweils von einer der zweiten Öffnungen (15) ringförmig umgeben wird, wobei zwischen der ersten Öffnung (12) und der zweiten Öffnung (15) jeweils ein Teil der dielektrischen Schicht (11) angeordnet ist,
- bei dem benachbarte zweite Öffnungen (15) miteinander verbunden sind,
- bei dem die ersten Elektroden (13) und die zweiten Elektroden (16) durch Abscheiden und Rückätzen einer gemeinsamen leitfähigen Schicht gebildet werden.

12. Verfahren nach einem der Ansprüche 6 bis 10,
- bei dem zunächst die ersten Öffnungen (12) und die ersten Elektroden (13) erzeugt werden,
- bei dem mindestens die Oberfläche der ersten Elektroden (13) mit einer Isolationsschicht (14) versehen wird,
- bei dem die zweiten Öffnungen (15) gebildet werden,
- bei dem durch Abscheidung einer leitenden Schicht die zweiten Elektroden (16) und eine Kondensatorplatte (17) gebildet werden, die die zweiten Elektroden (16) elektrisch miteinander verbindet.

13. Verfahren nach einem der Ansprüche 6 bis 12, bei dem die Bitleitungen (6) und die Wortleitungen (5) unter der isolierenden Schicht (8) gebildet werden.
